# EUROPEAN PATENT SPECIFICATION

(11) **EP 4 277 246 B1**
(45) Date of publication and mention of the grant of the patent: **17.09.2025**
(21) Application number: 22902455.9
(22) Date of filing: 15.12.2022
(51) Int. Cl.: H04M 1/02

(54) **FOLDABLE DEVICE**
ZUSAMMENKLAPPBARE VORRICHTUNG
DISPOSITIF PLIABLE

(30) Priority: 14.03.2022 CN 202210277265
(43) Date of publication of application: 15.11.2023
(73) Proprietor: Honor Device Co., Ltd., Shenzhen, Guangdong 518040 (CN)
(72) Inventor: YAN, Bin, Shenzhen, Guangdong 518040 (CN)
(74) Representative: Beder, Jens
(86) International application number: PCT/CN2022/139347
(87) International publication number: WO 2023/173857

(56) References cited:
- EP-A1- 3 745 689
- EP-A1- 3 876 504
- CN-A- 106 713 542
- CN-A- 110 557 481
- CN-A- 110 995 892
- CN-A- 113 053 238
- CN-A- 113 497 843
- CN-A- 113 805 646
- CN-A- 113 889 011
- CN-U- 208 421 694
- CN-U- 213 585 854
- US-A1- 2012 264 489
- US-A1- 2016 299 539
- US-B1- 10 601 968

## Description

### CROSS-REFERENCE TO RELATED APPLICATIONS

This application claims priority to Chinese Patent Application CN 116 798 311 A (Application No. 202210277265.0), filed with the China National Intellectual Property Administration on March 14, 2022 and entitled "FOLDABLE DEVICE".

### TECHNICAL FIELD

This application relates to the field of foldable devices, and in particular, to a foldable device.

### BACKGROUND

A known trifold device usually has an inward and outward folding design. To be specific, the foldable device has two folds, including one inward fold (an inward fold of a screen) and one outward fold (an outward fold of the screen).

However, in a foldable device using an inward and outward folding solution, there is a problem that a rotating shaft structure is complex, and a flexible display needs to meet both inward and outward folding requirements.

With regard to the prior art, reference is made to the patent applications US 2016/299539 A1 and CN 110 995 892 A.

US 2016/299539 A1 discloses a foldable device comprising a first body portion, a second body portion and a third body portion that are sequentially disposed, wherein the first body portion and the third body portion are respectively rotatably connected to two sides in a width direction of the second body portion, the first body portion is capable of being folded to overlap the second body portion, and the third body portion is capable of being folded to overlap the folded first body portion.

CN 110 995 892 A discloses a foldable device comprising a first body portion and a second body portion rotatably connected to the first body portion and having a wedge shape whose thickness gradually changes in the width direction.

Further reference is made to the patent applications US 2012/264489 A1, EP 3 876 504 A1, CN 113 805 646 A, and EP 3 745 689 A1.

### SUMMARY

To solve a problem of reducing the overall thickness of the foldable device and a problem that in a foldable device folded inward and outward, a rotating shaft structure is complex, and a flexible display needs to meet both inward and outward folding requirements, embodiments of the present application provides a foldable device according to the enclosed claim 1. Advantageous features of the present invention are defined in the corresponding subclaims. In the following, parts of the description and drawings referring to embodiments, which are not covered by the claims, are not presented as embodiments of the invention but as examples useful for understanding the invention.

According to a first aspect, an embodiment of this application provides a foldable device, including a body and a flexible display. The body includes a first body portion, a second body portion, and a third body portion that are sequentially disposed, and the first body portion and the third body portion are respectively rotatably connected to two sides in a width direction of the second body portion; the flexible display includes a first screen portion, a first bent-screen portion, a second screen portion, a second bent-screen portion, and a third screen portion that are sequentially connected, the first screen portion is attached to a front face of the first body portion, the second screen portion is attached to a front face of the second body portion, and the third screen portion is attached to a front face of the third body portion; the first body portion is capable of being folded to overlap the second body portion, so that the first screen portion and the second screen portion are opposite to each other and sandwiched between the front face of the first body portion and the front face of the second body portion; and the third body portion is capable of being folded to overlap the folded first body portion, so that the third screen portion is sandwiched between a rear face of the first body portion and the front face of the third body portion; and a thickness of a side that is of the first body portion and that is connected to the second body portion is large, and a thickness of a side that is of the first body portion and that is away from the second body portion is small.

In the foldable device in this embodiment of this application, an inward folding manner is used between the first body portion and the second body portion and between the third body portion and the second body portion, the thickness of the side that is of the first body portion and that is close to the second body portion is large, and the thickness of the side that is of the first body portion and that is away from the second body portion is small, so that design difficulty of a rotatable connection structure between the first body portion and the second body portion is reduced, and space existing between the second body portion and the third body portion after the second body portion and the third body portion rotate is fully used to help reduce an overall thickness of the foldable device. In addition, in the structure, the flexible display is sandwiched between inner sides of the body portions and is difficult to damage, the flexible display only needs to meet an inward folding requirement, and a requirement on performance of the flexible display is low.

In a possible implementation, the first body portion is in a wedge shape whose thickness gradually changes in a width direction.

In this implementation, the first body portion is in the wedge shape, and has an aesthetic appearance after being unfolded. When the first body portion is folded, the space between the second body portion and the third body portion can be fully used, to help reduce a total thickness of the folded foldable device and the design difficulty of the rotatable connection structure between the first body portion and the second body portion.

In a possible implementation, an included angle between the front face and the rear face of the first body portion ranges from 0.5° to 2°.

In this implementation, the included angle is set to range from 0.5° to 2°, so that the thickness of the first body portion gradually changes, without exerting too large impact on the appearance of the first body portion.

In a possible implementation, the thickness of the side that is of the first body portion and that is connected to the second body portion ranges from 4 mm to 8 mm, the thickness of the side that is of the first body portion and that is away from the second body portion ranges from 2 mm to 5 mm, an included angle between the front face and the rear face of the first body portion ranges from 0.5° to 2°; a thickness of the second body portion ranges from 4 mm to 8 mm, and the front face and a rear face of the second body portion are parallel to each other; and a thickness of a side that is of the third body portion and that is connected to the second body portion ranges from 5 mm to 8 mm, a thickness of a side that is of the third body portion and that is away from the second body portion ranges from 2 mm to 8 mm, and an included angle between the front face and a rear face of the first body portion ranges from 0° to 2°.

In this implementation, a proper size is set, to obtain a foldable device with a small thickness.

In a possible implementation, the third body portion is in a wedge shape whose thickness gradually changes in a width direction, a thickness of a side that is of the third body portion and that is connected to the second body portion is large, and a thickness of a side that is of the third body portion and that is away from the second body portion is small; and an included angle between the front face and a rear face of the third body portion is equal to an included angle between the front face and the rear face of the first body portion.

In this implementation, after the first body portion is folded to overlap the second body portion and the third body portion is folded to overlap the first body portion, the rear face of the first body portion and the front face of the third body portion are fitted after overlapping, and the thickness of the first body portion and a thickness of the third body portion are in a complementary state, so that an overall thickness of the first body portion and the third body portion are kept basically constant, the folded foldable device is in a common state in which a front face and a rear face (that is, a rear face of a second housing and a rear face of a third housing) are parallel to each other, and an appearance of an electronic device conforms to a habit of a consumer. Certainly, in this embodiment, "parallel" does not need to be "completely parallel". Instead, an included angle that is slightly greater than 0° and that is caused due to impact exerted by shape and position tolerances within a specific range is allowed, for example, an included angle within a range from 0 to 1°.

In a possible implementation, the front face and a rear face of the third body portion are parallel.

In this implementation, the thickness of the side that is of the third body portion and that is away from the second body portion can be set to be large. Although the front face and the rear face of the folded foldable device are not parallel to each other, it is convenient to dispose a side button (for example, a power button or a volume button) and dispose more structures inside the third body portion. In addition, when an included angle between the front face and the rear face of the folded foldable device is not large (for example, less than 5°), little impact is exerted on an overall appearance and use experience of the device.

In a possible implementation, a button structure is disposed on a side of that is the third body portion and that is away from the second body portion.

In this implementation, the side of that is the third body portion and that is away from the second body portion is exposed, to help dispose and operate the button structure.

In a possible implementation, the first body portion includes a wedge-shaped portion whose thickness gradually changes in a width direction and an equal-thickness portion that has a constant thickness and that is connected to one or two sides in a width direction of the wedge-shaped portion.

In this implementation, the first body portion is partially in a wedge shape, partially has an equal thickness, and has different shapes.

In a possible implementation, a wedge angle of the wedge-shaped portion ranges from 0.5° to 1.8°.

This implementation provides the range of the wedge angle of the first body portion that is in the wedge shape and that partially has an equal thickness.

In a possible implementation, in a state in which the first body portion is folded to overlap the second body portion, the first screen portion and the second screen portion overlap each other, and the first bent-screen portion is bent into a water drop shape; and in a state in which the third body portion is folded to overlap the folded first body portion, the third screen portion overlaps the rear face of the first body portion, and the second bent-screen portion is bent into a U shape.

In this implementation, based on the wedge-shaped design of the first body portion, the second screen portion and the third screen portion need to rotate by a degree less than 180° to change from an unfolded state to a folded state. Compared with a common solution of rotating by 180°, a requirement on folding performance of the flexible display is lowered.

In a possible implementation, in the state in which the first body portion is folded to overlap the second body portion, the first screen portion and the second screen portion are fitted or at a distance less than 1.0 mm, the first bent-screen portion bent into the water drop shape includes an arc section, a first transition section, and a second transition section, the first transition section is transitionally connected between the arc section and the first screen portion, and the second transition section is transitionally connected between the arc section and the second screen portion.

In this implementation, in a water-drop-shaped bend solution of the flexible display, screens have a small distance from each other or are even directly fitted, to reduce a total thickness of a folded structure. However, to realize the water-drop-shaped bend solution, there is a high requirement on thicknesses of body portions (rotatable connection positions of the first body portion and the second body portion in this embodiment) on two sides of a water-drop-shaped bend, and this is inconducive to control of the total thickness existing after folding. In a U-shaped bend solution of the flexible display, there is a large distance after folding, and control of the total thickness existing after folding is limited. In this embodiment, the first body portion is arranged in a wedge shape, to skillfully implement a design that a thickness of a side that is of the first body portion and that is close to a water-drop-shaped bend is large (which helps meet a requirement on a thickness of the first body portion at a connection point in the water-drop-shaped bend solution), and a thickness of a side that is of the first body portion and that is close to a U-shaped bend is small (a required distance at the U-shaped bend is reduced, and space within a range of the distance is fully used). A structure is very compact, so that the thickness of the folded foldable device can be greatly reduced compared with that in the conventional technology.

In a possible implementation, the first body portion and the second body portion are rotatably connected by using a first rotation structure; and the third body portion and the second body portion are rotatably connected by using a second rotation structure.

In this implementation, the first rotation structure and the second rotation structure are used to implement a rotatable connection of adjacent body portions.

In a possible implementation, the first rotation structure and/or the second rotation structure are/is a hinge structure.

In this implementation, the hinge structure is used to better implement the rotatable connection of adjacent body portions.

In a possible implementation, the foldable device further includes a first support structure and a second support structure, the first support structure is configured to support the first bent-screen portion, and the second support structure is configured to support the second bent-screen portion.

In this implementation, the first support structure and the second support structure can support the first bent-screen portion and the second bent-screen portion, so that the water-drop-shaped bend or U-shaped bend of the flexible display is realized, and the flexible display is entirely on one plane when being unfolded.

In a possible implementation, the first support structure includes a first support plate, a second support plate, and a third support plate; the first support plate is rotatably connected to the first body portion, the second support plate is rotatably connected to the second body portion, and the third support plate is fixedly connected to the first rotation structure; in a state in which the first body portion and the second body portion are relatively unfolded, the first support plate and the second support plate are respectively located on two sides of the third support plate, and support faces of the first support plate, the second support plate, and the third support plate are on a same plane to jointly support the first bent-screen portion; and in a state in which the first body portion and the second body portion are folded to overlap each other, the first bent-screen portion is in a water drop shape, the first support plate rotates to a state of being parallel to the first transition section and supports the first transition section from below, the second support plate rotates to a state of being parallel to the second transition section and supports the second transition section from below, and the third support plate supports the arc section from below.

In this implementation, the first support plate, the second support plate, and the third support plate can reliably support the second bent-screen portion in both the folded state and the unfolded state of the foldable device.

In a possible implementation, the second support structure includes a fourth support plate and a fifth support plate; the fourth support plate is fixedly connected to a side that is of the second body portion and that is close to the third body portion, and the fifth support plate is fixedly connected to a side that is of the third body portion and that is close to the second body portion; in a state in which the third body portion and the second body portion are relatively unfolded, support faces of the fourth support plate and the fifth support plate are on a same plane to jointly support the second bent-screen portion; and in a state in which the third body portion and the second body portion are relatively folded into a folded state, the fourth support plate synchronously rotates along with the second body portion to provide support near a junction of the second screen portion and the second bent-screen portion, and the fifth support plate synchronously rotates along with the third body portion to provide support near a junction of the third screen portion and the second bent-screen portion.

In this implementation, the fourth support plate and the fifth support plate can reliably support the second bent-screen portion in both the folded state and the unfolded state of the foldable device.

In a possible implementation, a secondary display is further disposed on a rear face of the third body portion, and a protective glass plate is disposed on an outer side of the secondary display.

In this implementation, the secondary display is disposed, so that the folded foldable device has a display function.

In a possible implementation, a front-facing camera is disposed on the rear face of the third body portion, and the front-facing camera penetrates the secondary display or is located on an inner side of the secondary display.

In this implementation, the secondary display disposed on the rear face of the third body portion can implement display in the folded state.

In a possible implementation, the foldable device further includes a rear-facing camera and/or a main battery, and the rear-facing camera and/or the main battery are/is disposed on the second body portion.

In this implementation, the second body portion has a regular size and a large thickness, to help dispose a camera assembly of a proper size.

In a possible implementation, the foldable device includes a flexible-display lead-out wire and an antenna; and the flexible-display lead-out wire is led out from a thinner side that is of the flexible display and that corresponds to the first body portion, and the antenna is disposed on a side that is of the third body portion and that is away from the second body portion.

In this implementation, the first body portion is sandwiched between the second body portion and the third body portion, and it is not suitable to dispose a folded-state antenna on an edge of the first body portion. Therefore, the flexible-display lead-out wire is led out from an edge of the first body portion, the side that is of the third body portion and that is away from the second body portion is not shielded, and disposing the antenna on the side is not prone to affecting antenna signal quality.

In a possible implementation, the first body portion includes a first-body-portion body and a first side housing connected to the first-body-portion body, the second body portion includes a second-body-portion body and a second side housing connected to the second-body-portion body, the third body portion includes a third-body-portion body and a third side housing connected to the third-body-portion body, and the flexible display includes a display area and an outer edge area located on a periphery of the display area; the flexible display is laid on front faces of the first-body-portion body, the second-body-portion body, and the third-body-portion body; and the first side housing, the second side housing, and the third side housing jointly form an outer side-housing frame around a periphery of the body, the outer edge area is sandwiched between the outer side-housing frame and each of the first-body-portion body, the second-body-portion body, and the third-body-portion body, and a width-direction gap exists between one or two sides of the outer side-housing frame in a width direction of the foldable device and a corresponding side of the flexible display, to allow the flexible display to displace relative to a width direction of the body when the foldable device changes between different folding states.

In this implementation, in a structural arrangement of a body portion, a displacement existing in a width direction when the flexible display is bent can be allowed. In addition, the first side housing, the second side housing, and the third side housing protrude from an outer surface of the flexible display, and the side housings abut against each other after folding, to prevent the flexible display from being in contact with an opposite-side structure, and reduce a friction and damage possibility.

In a possible implementation, a notch is disposed in each of a position that is in the outer side-housing frame and that corresponds to a rotatable connection point between the first body portion and the second body portion and a position that is in the outer side-housing frame and that corresponds to a rotatable connection point between the third body portion and the second body portion.

In this implementation, the notch is disposed, to avoid bending abutment between the first side housing and the second side housing and between the second side housing and the third side housing.

In a possible implementation, a part that is of the rear face of the first body portion and that is located on a side that is of the first body portion and that is away from the second body portion is recessed in a thickness direction of the first body portion, to form avoidance space, so that the first body portion is in a step shape in which a thickness of a part corresponding to the avoidance space is small and a thickness of a part outside the avoidance space is large; and the third body portion is accommodated in the avoidance space when overlapping the first body portion.

In this implementation, the first body portion is arranged in the step shape, so that the side that is of the first body portion and that is close to the second body portion is thick, and the side that is of the first body portion and that is away from the second body portion is thin, to help reduce the overall thickness.

### BRIEF DESCRIPTION OF DRAWINGS

To describe the technical solutions in embodiments of this application more clearly, the following briefly describes the accompanying drawings in the embodiments. It should be understood that, the accompanying drawings below only show some embodiments of this application, and thus should not be considered as limitations on the scope. A person of ordinary skill in the art may still derive other related drawings from the accompanying drawings without creative efforts.
FIG. 1 is a schematic diagram of a structure in a first implementation of a foldable device according to an embodiment, which does not relate to the subject matter of the enclosed claims and where the foldable device is in an unfolded state;
FIG. 2 is a top view of the foldable device in FIG. 1;
FIG. 3 is a schematic diagram of a structure existing when the foldable device in FIG. 1 is folded into a folded state;
FIG. 4 is a top view of the foldable device in FIG. 3;
FIG. 5 is a schematic diagram of a structure existing when the foldable device in FIG. 1 is folded into an intermediate state;
FIG. 6 is a schematic diagram of a structure in a second implementation of a foldable device according to an embodiment, which does not relate to the subject matter of the enclosed claims and where the foldable device is in a folded state;
FIG. 7 is a schematic diagram of a structure in a third implementation of a foldable device according to an embodiment, which does not relate to the subject matter of the enclosed claims and where the foldable device is in a folded state;
FIG. 8 is a schematic diagram of a structure in a fourth implementation of a foldable device according to an embodiment of this application, where the foldable device is in a folded state;
FIG. 9 is a schematic diagram of a structure existing when the foldable device in FIG. 8 is unfolded;
FIG. 10 is an enlarged view of a position A in FIG. 9;
FIG. 11 is an enlarged view of a position B in FIG. 9;
FIG. 12 is a schematic diagram of a structure in a fifth implementation of a foldable device according to an embodiment, which does not relate to the subject matter of the enclosed claims and where the foldable device is in a folded state;
FIG. 13 is a top view of the foldable device in FIG. 12, where the foldable device is in an unfolded state;
FIG. 14 is a schematic diagram of a structure in a sixth implementation of a foldable device according to an embodiment of this application, where the foldable device is in a folded state; and
FIG. 15 is a schematic diagram of a structure in a seventh implementation of a foldable device according to an embodiment, which does not relate to the subject matter of the enclosed claims and where the foldable device is in a folded state.

**Description of reference numerals of main elements:**

| | |
|---|---|
| Foldable device | 10 |
| Body | 11 |
| Flexible display | 12 |
| First screen portion | 12a |
| Second screen portion | 12b |
| Third screen portion | 12c |
| First bent-screen portion | 12d |
| Second bent-screen portion | 12e |
| Display area | 12f |
| Outer edge area | 12g |
| First transition section | d1 |
| Second transition section | d2 |
| Arc section | d3 |
| First body portion | 13 |
| First-body-portion body | 13a |
| First side housing | 13b |
| Wedge-shaped portion | 131 |
| Equal-thickness portion | 132 |
| Second body portion | 14 |
| Second-body-portion body | 14a |
| Second side housing | 14b |
| Third body portion | 15 |
| Third-body-portion body | 15a |
| Third side housing | 15b |
| First rotation structure | 16 |
| Second rotation structure | 17 |
| First support structure | 18 |
| Second support structure | 19 |
| First support plate | 20 |
| Second support plate | 21 |
| Third support plate | 22 |
| Fourth support plate | 23 |
| Fifth support plate | 24 |
| Front-facing camera | 25 |
| Secondary display | 26 |
| Secondary-display lead-out wire | 26a |
| Protective glass plate | 27 |
| Button structure | 28 |
| Rear-facing camera | 29 |
| Main battery | 30 |
| Flexible-display lead-out wire | 31 |
| Antenna | 32 |
| Driver chip | 33 |
| Outer side-housing frame | 34 |
| Avoidance space | C1 |
| Width-direction gap | f1 |
| Through hole | K1 |
| Notch | K2 |
| Support face | P1 and P2 |
| Front face | S1 |
| Rear face | S2 |
| Width direction | Y1 |
| Thickness direction | Y2 |

### DESCRIPTION OF EMBODIMENTS

The following clearly and completely describes the technical solutions in embodiments of this application with reference to the accompanying drawings in the embodiments of this application. It is clear that the described embodiments are only some but not all of the embodiments of this application.

It should be noted that when a component is referred to as being "fastened to" another component, the component may be directly fastened to the another component, or there may be a component between the component and the another component. When a component is considered as being "connected to" another component, the component may be directly connected to the another component, or there may be a component between the component and the another component. When a component is considered as being "disposed on" another component, the component may be directly disposed on the another component, or there may be a component between the component and the another component. The terms "perpendicular", "horizontal", "left", "right", and other similar expressions as used in this specification are for illustration only.

Unless otherwise defined, meanings of all technical and scientific terms used in this specification are the same as those usually understood by a person skilled in the art to which this application belongs. The terms used herein in the specification of this application are merely intended to describe specific implementations but not intended to limit this application. The term "or/and" used in this specification includes any or all combinations of one or more related listed items.

Some implementations of this application are described in detail. In absence of conflicts, the following implementations and features in the implementations may be combined.

### Embodiment

An embodiment of this application provides some implementations of a foldable device. The foldable device may be a foldable mobile phone, a foldable tablet computer, or another foldable device.

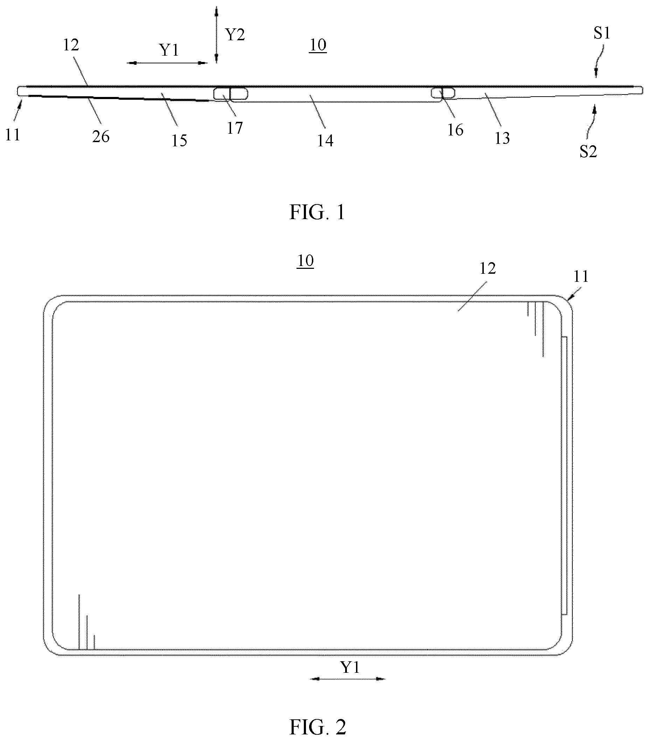

Referring to FIG. 1 to FIG. 5, a foldable device 10 includes a body 11 and a flexible display 12.

The body 11 includes a first body portion 13, a second body portion 14, and a third body portion 15 that are sequentially disposed, and the first body portion 13 and the third body portion 15 are respectively rotatably connected to two sides in a width direction Y1 of the second body portion 14. If the foldable device 10 needs to be provided with a mechanical structure or an electronic component such as a housing, a battery, a main board, a camera assembly, a button assembly, or an antenna, the mechanical structure or the electronic component may be properly distributed on the three body portions: the first body portion 13, the second body portion 14, and the third body portion 15 based on a requirement. For example, a structure such as a main battery or a rear-facing camera that occupies large thickness space may be disposed on a body portion (for example, the second body portion 14) with a large thickness, and the button assembly may be disposed in a position that facilitates an operation, such as a side edge of the third body portion 15.

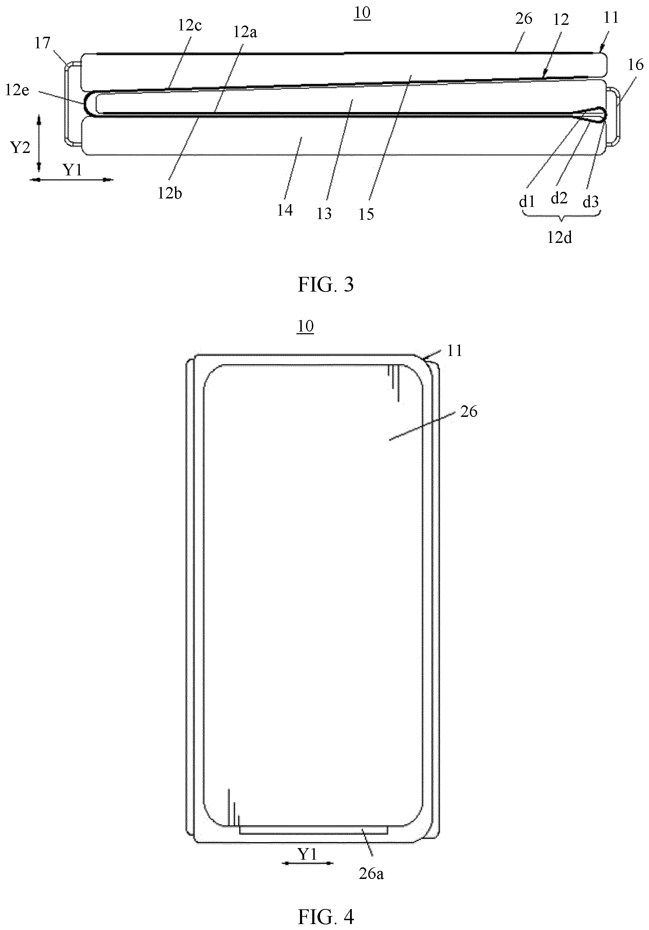

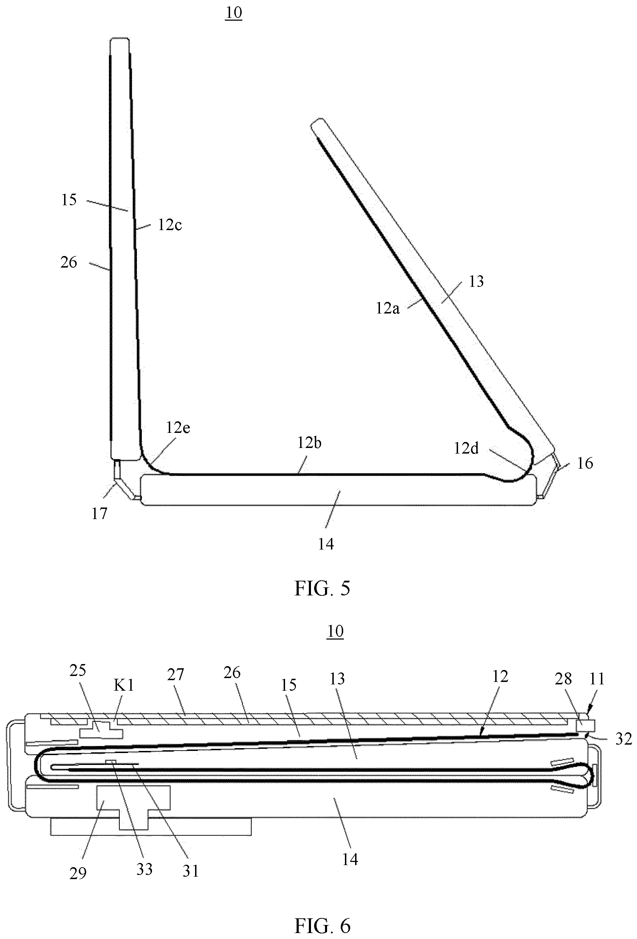

Through relative rotation, the first body portion 13, the second body portion 14, and the third body portion 15 can be rotated into an unfolded state (referring to FIG. 1 and FIG. 2), a folded state (referring to FIG. 3 or FIG. 4), and an intermediate state (referring to FIG. 5) between the folded state and the unfolded state. Usually, the folded state and the unfolded state are two common use states of the foldable device 10. Certainly, some intermediate states may also be designed as common use states.

The flexible display 12 is a foldable flexible structure, and may be of a flexible structure in which the flexible display 12 may be bent in any position, for example, may be an organic light-emitting diode (organic light-emitting diode, OLED) display, an active-matrix organic light-emitting diode or an active-matrix organic light-emitting diode (active-matrix organic light-emitting diode, AMOLED) display, a mini organic light-emitting diode (mini organic light-emitting diode) display, a micro light-emitting diode (micro organic light-emitting diode) display, a micro organic light-emitting diode (micro organic light-emitting diode) display, or a quantum dot light emitting diode (quantum dot light emitting diodes, QLED) display. The flexible display 12 may alternatively be of a structure in which the flexible display 12 may be bent only in some positions but cannot be bent or have a non-bendable design in another position.

In an inward folding manner used in this embodiment, the flexible display 12 is folded on an inner side, and is usually also referred to as an "inner screen". Correspondingly, a screen facing an outside after being folded is referred to as an "outer screen" (for example, a secondary display 26 described below).

In this embodiment, the flexible display 12 includes a first screen portion 12a, a first bent-screen portion 12d, a second screen portion 12b, a second bent-screen portion 12e, and a third screen portion 12c that are sequentially connected.

The first screen portion 12a is attached to a front face S1 of the first body portion 13, the second screen portion 12b is attached to a front face S1 of the second body portion 14, the third screen portion 12c is attached to a front face S1 of the third body portion 15, the first bent-screen portion 12d approximately corresponds to a rotatable connection point between the first body portion 13 and the second body portion 14, and the second bent-screen portion 12e approximately corresponds to a rotatable connection point between the third body portion 15 and the second body portion 14. Each body portion has a front face S1 and a rear face S2 that are opposite in a thickness direction Y2, one face in which the flexible display 12 is located is defined as the front face S1, and the other face is defined as the rear face S2. "Attach" herein may be an adhesive manner or another connection manner. Certainly, in some embodiments, attachment between the flexible display 12 and a body portion allows the flexible display 12 to have a specific relative displacement relative to the body portion, so as to adapt to misalignment between the flexible display 12 and a body portion when the flexible display 12 is bent. When the misalignment is small and negligible, "attach" may alternatively be a completely fixed mating connection.

In the flexible display 12, the first bent-screen portion 12d and the second bent-screen portion 12e are of a bendable structure, and the first screen portion 12a, the second screen portion 12b, and the third screen portion 12c may be of a bendable structure or may be of a rigid structure. In some implementations, the flexible display 12 is of an integral screen structure, and the first screen portion 12a, the first bent-screen portion 12d, the second screen portion 12b, the second bent-screen portion 12e, and the third screen portion 12c have no significant structural performance difference.

Referring to FIG. 4, the first body portion 13 can be folded to overlap the second body portion 14, so that the first screen portion 12a and the second screen portion 12b are opposite to each other and are sandwiched between the front face S1 of the first body portion 13 and the front face S1 of the second body portion 14. Herein, the first screen portion 12a and the second screen portion 12b may be fully fitted or there may be a small gap (for example, less than 1.0 mm). In actual use, the gap may be 0.9 mm, 0.7 mm, 0.5 mm, or the like. The third body portion 15 can be folded to overlap the folded first body portion 13, so that the third screen portion 12c is sandwiched between a rear face S2 of the first body portion 13 and the front face S1 of the third body portion 15. The third screen portion 12c and the rear face S2 of the first body portion 13 may be fully fitted or there may be a small gap (for example, less than 1.0 mm). A smaller gap leads to a smaller total thickness of the foldable device 10 in a folded state. When the gap is not zero, a scratch possibly caused by contact and friction on an outer surface of the flexible display 12 can be prevented. When the gap is zero, a design may be needed to prevent a surface of the flexible display 12 from being scratched. For example, a wear-resistant surface is used, a structure that prevents body portions from sliding relative to each other in the folded state is used, or another feasible anti-scratching design is used. To limit the gap, a specific protrusion structure (for example, an outer side-housing frame 34 in the following embodiment) protruding from the flexible display 12 may exist between corresponding body portions, and the protrusion structure limits overlapped body portions, to ensure that a controllable gap can exist between the outer surface of the flexible display 12 and an opposite-side structure.

Referring to FIG. 2, FIG. 4, and FIG. 5, a thickness of a side that is of the first body portion 13 and that is connected to the second body portion 14 is large, and a thickness of a side that is of the first body portion 13 and that is away from the second body portion 14 is small.

In the foldable device 10, an inward folding manner is used between the first body portion 13 and the second body portion 14 and between the third body portion 15 and the second body portion 14, the thickness of the side that is of the first body portion 13 and that is close to the second body portion 14 is large, and the thickness of the side that is of the first body portion 13 and that is away from the second body portion 14 is small, so that design difficulty of a rotatable connection structure between the first body portion 13 and the second body portion 14 is reduced, and space existing between the second body portion 14 and the third body portion 15 after the second body portion 14 and the third body portion 15 rotate is fully used to help reduce an overall thickness of the foldable device 10. In addition, in the structure, the flexible display 12 is sandwiched between inner sides of the body portions and is difficult to damage, the flexible display 12 only needs to meet an inward folding requirement, and a requirement on performance of the flexible display 12 is low.

In an implementation, the first body portion 13 is in a wedge shape whose thickness gradually changes in the width direction Y1. For example, an included angle between the front face S1 and the rear face S2 of the first body portion 13 is set to be from 0.5° to 2°. Certainly, a wedge-shaped portion of the first body portion 13 may extend to only one section in the width direction Y1 of the first body portion 13. In other words, in the width direction Y1 of the first body portion 13, a thickness of a part of the first body portion 13 may be kept constant, and a thickness of the other part of the first body portion 13 gradually changes.

The first body portion 13 is designed to be in the wedge shape, and has an aesthetic appearance after being unfolded. When the first body portion 13 is folded, the space between the second body portion 14 and the third body portion 15 can be fully used, to help reduce a total thickness of the folded foldable device 10 and design difficulty of a rotatable connection structure between the first body portion 13 and the second body portion 14.

In some implementations, a secondary display 26 is further disposed on a rear face S2 of the third body portion 15, so that the folded foldable device 10 has a display function. A secondary-display lead-out wire 26a (referring to FIG. 4) of the secondary display may be led out from a lower side of the secondary display. The secondary display 26 does not need to have a folding function. Therefore, a protective glass plate 27 may be disposed on an outer side of the secondary display 26, to protect the secondary display 26. Certainly, the secondary display 26 may be omitted and is not disposed.

In this embodiment, both the front face S1 and the rear face S2 of the first body portion 13 are planes. In some other embodiments, the front face S1 and the rear face S2 of the first body portion 13 are arc surfaces, but the thickness of the side that is of the first body portion 13 and that is close to the second body portion 14 needs to be kept large and the thickness of the side that is of the first body portion 13 and that is away from the second body portion 14 needs to be kept small.

In an implementation, as shown in FIG. 4 or FIG. 6, to adapt to the arrangement of the wedge shape of the first body portion 13, the third body portion 15 is in a wedge shape whose thickness gradually changes in the width direction Y1, a thickness of a side that is of the third body portion 15 and that is connected to the second body portion 14 is large, and a thickness of a side that is of the third body portion 15 and that is away from the second body portion 14 is small. An included angle between the front face S1 and the rear face S2 of the third body portion 15 is equal to the included angle between the front face S1 and the rear face S2 of the first body portion 13. Therefore, after the first body portion 13 is folded to overlap the second body portion 14 and the third body portion 15 is folded to overlap the first body portion 13, the rear face S2 of the overlapped first body portion 13 and the front face S1 of the third body portion 15 are fitted, and a thickness of the first body portion 13 and a thickness of the third body portion 15 are in a complementary state, to keep an overall thickness of the first body portion 13 and the third body portion 15 to be basically constant, so that the folded foldable device 10 is in a common state in which a front face S1 and a rear face S2 (that is, a rear face S2 of a second housing and a rear face S2 of a third housing) are parallel to each other, and an appearance of an electronic device conforms to a habit of a consumer.

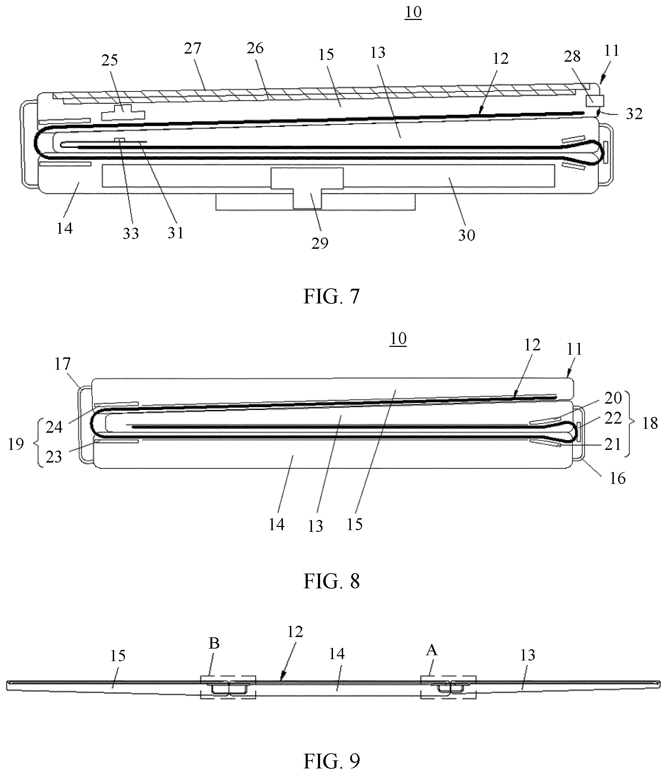

In some other implementations, the front face S1 and the rear face S2 of the third body portion 15 are parallel (as shown in FIG. 7), or the included angle is less than the included angle between the front face S1 and the rear face S2 of the first body portion 13. In this case, the thickness of the side that is of the third body portion 15 and that is away from the second body portion 14 may be set to be large. Although the front face S1 and the rear face S2 of the folded foldable device 10 may be unparallel to each other, it is convenient to dispose a button structure 28 (for example, a power button or a volume button) and dispose more other structures (for example, an in-screen camera) inside the third body portion 15. In addition, when the included angle between the front face S1 and the rear face S2 of the folded foldable device 10 is not large (for example, less than 2°), little impact is exerted on an overall appearance and use experience of the device.

Based on the foregoing implementations, a size of a body portion in this embodiment may be designed as follows: The thickness of the side that is of the first body portion 13 and that is connected to the second body portion 14 ranges from 4 mm and 8 mm, the thickness of the side that is of the first body portion 13 and that is away from the second body portion 14 ranges from 2 mm to 5 mm, and the included angle between the front face S1 and the rear face S2 of the first body portion 13 ranges from 0.5° to 2°; a thickness of the second body portion 14 ranges from 4 mm to 8 mm, and the front face S1 and the rear face S2 of the second body portion 14 are parallel to each other; the thickness of the side that is of the third body portion 15 and that is connected to the second body portion 14 ranges from 5 mm to 8 mm, the thickness of the side that is of the third body portion 15 and that is away from the second body portion 14 ranges from 2 mm to 8 mm, and the included angle between the front face S1 and the rear face S2 of the first body portion 13 ranges from 0° to 2°. In this way, the foldable device 10 whose thickness meets a use requirement before and after folding can be obtained.

Referring mainly to FIG. 3, in some implementations, in a state in which the first body portion 13 is folded to overlap the second body portion 14, the first screen portion 12a and the second screen portion 12b overlap each other, and the first bent-screen portion 12d is bent into a water drop shape. In a state in which the third body portion 15 is folded to overlap the folded first body portion 13, the third screen portion overlaps the rear face S2 of the first body portion 13, and the second bent-screen portion 12e is bent into a U shape (also referred to as a baseball shape). In this implementation, based on the wedge-shaped design of the first body portion 13, the second screen portion 12b and the third screen portion 12c need to rotate by a degree less than 180° to change from an unfolded state to a folded state. Compared with a common solution of rotating by 180°, a requirement on folding performance of the flexible display 12 is lowered.

In the state in which the first body portion 13 is folded to overlap the second body portion 14, the first screen portion 12a and the second screen portion 12b are fitted or at a distance less than 1.0 mm, and the first bent-screen portion 12d bent into the water drop shape includes an arc section d3, a first transition section d1, and a second transition section d2. The first transition section d1 is transitionally connected between the arc section d3 and the first screen portion 12a, and the second transition section d2 is transitionally connected between the arc section d3 and the second screen portion 12b.

In a water-drop-shaped bend solution of the flexible display 12, screens have a small distance from each other or are even directly fitted, to reduce a total thickness of a folded structure. However, to realize the water-drop-shaped bend solution, there is a high requirement on thicknesses of body portions (rotatable connection positions of the first body portion 13 and the second body portion 14 in this embodiment) on two sides of a water-drop-shaped bend, and this is inconducive to control of the total thickness existing after folding. In a U-shaped bend solution of the flexible display 12, there is a large distance after folding, and control of the total thickness existing after folding is limited. In this embodiment, the first body portion 13 is arranged in the wedge shape, to skillfully implement a design that a thickness of a side that is of the first body portion 13 and that is close to a water-drop-shaped bend is large (which helps meet a requirement on a thickness of the first body portion 13 at a connection point in the water-drop-shaped bend solution), and a thickness of a side that is of the first body portion 13 and that is close to a U-shaped bend is small (a required distance at the U-shaped bend is reduced, and space within a range of the distance is fully used). A structure is very compact, so that a thickness of the folded foldable device can be greatly reduced compared with that in the conventional technology.

In the water-drop-shaped bend solution in this embodiment, except a shape including the arc section d3, the first transition section d1, and the second transition section d2, a shape including only a single arc (not shown in the figure) may be used, provided that the first bent-screen portion 12d is integrally in a contraction-cavity shape, so that two screen portions (for example, the first screen portion 12a and the second screen portion 12b in this embodiment) connected to the first bent-screen portion 12d can be kept at a small distance (for example, a distance within 1.0 mm) for fitting, even in a position connected to the vicinity of the water-drop-shaped portion. Alternatively, in the water-drop-shaped bend solution, the first bent-screen portion 12d includes both a bending center located on an inner side and a bending center located on an outer side (for example, in this embodiment, a bending center of the arc section is located on an inner side of the water drop shape, and a bending center of connection points between the two transition sections and two corresponding screen portions is located on an outer side of the water drop shape).

In the U-shaped (also referred to as the baseball shape) bend solution, only the bending center located on the inner side exists. Because a bending radius of the flexible display 12 cannot be set to be too small, in a U-shaped connection solution, a distance between two connected screen portions (for example, the second screen portion 12b and the third screen portion 12c in this embodiment) usually cannot be set to be as small as that in the water-drop-shaped connection solution in a position close to a U-shaped opening (for example, the distance ranges from 2.0 mm to 5.0 mm or has a larger value based on a material or performance of the flexible display 12). There are a plurality of solutions for implementing a rotatable connection between adjacent body portions. In this embodiment, the first body portion 13 and the second body portion 14 are rotatably connected by using a first rotation structure 16, and the third body portion 15 and the second body portion 14 are rotatably connected by using a second rotation structure 17. Optionally, the first rotation structure 16 and the second rotation structure 17 each are a hinge structure. The hinge structure usually includes an intermediate portion (not shown in the figure) and side connection portions (not shown in the figure) rotatably connected to two sides of the intermediate portion. Two body portions (for example, the first body portion 13 and the second body portion 14, or the second body portion 14 and the third body portion 15) that need to be rotatably connected are respectively connected to the two side connection portions, and the two body portions can be relatively rotated by using the hinge structure.

The first rotation structure 16, the second rotation structure 17, or the hinge structure applied to a rotatable connection between corresponding body portions in this embodiment may be realized by using another existing transformation structure including a plurality of rotation centers, or using a plurality of connecting rods, or having a same function, provided that the rotatable connection between the corresponding body portions can be implemented, and relative unfolding or folding of the body portions can be implemented. Details are not described herein again.

As shown in FIG. 8 to FIG. 11, the foldable device 10 further includes a first support structure 18 and a second support structure 19, the first support structure 18 is configured to support the first bent-screen portion 12d, and the second support structure 19 is configured to support the second bent-screen portion 12e.

Optionally, the first support structure 18 includes a first support plate 20, a second support plate 21, and a third support plate 22. The first support plate 20 is rotatably connected to the first body portion 13, the second support plate 21 is rotatably connected to the second body portion 14, and the third support plate 22 is fixedly connected to the first rotation structure 16. For example, when the first rotation structure 16 is in a form of the hinge structure, the third support plate 22 is fixedly connected to an intermediate portion of the hinge structure, and the first body portion 13 and the second body portion 14 are respectively connected to the two side connection portions. In addition, the first support plate 20 is rotatably connected to the first body portion 13, and the first support plate 20 and a side connection portion on the side implement a transmission connection by using a connecting rod structure (not shown in the figure) or the like. Based on a transmission manner such as a four-connecting-rod mechanism, when the first body portion 13 and the side connection portion rotate by approximately 180° relative to the intermediate portion to be folded from an unfolded state to a folded state, the rotation is transmitted to the first support plate 20 through the connecting rod structure, so that the first support plate 20 rotates by a corresponding angle relative to the first body portion 13, where the angle is, for example, equal to a bending angle of the first transition section d1 (that is, an angle at which the first transition section d1 is bent relative to the first screen portion 12a), to adaptively support the first transition section d1. The second support plate 21 is rotatably connected to the second body portion 14, and the second support plate 21 and a side connection portion on the side implement a transmission connection by using a connecting rod structure (not shown in the figure) or the like. Based on a transmission manner such as a four-connecting-rod mechanism, when the second body portion 14 and the side connection portion rotate by approximately 180° relative to the intermediate portion to be folded from an unfolded state to a folded state, the rotation is transmitted to the second support plate 21 through the connecting rod structure, so that the second support plate 21 rotates by a corresponding angle relative to the second body portion 14, where the angle is, for example, an angle equal to a bending angle of the second transition section d2 (that is, an angle at which the second transition section d2 is bent relative to the second screen portion 12b), to adaptively support the second transition section d2.

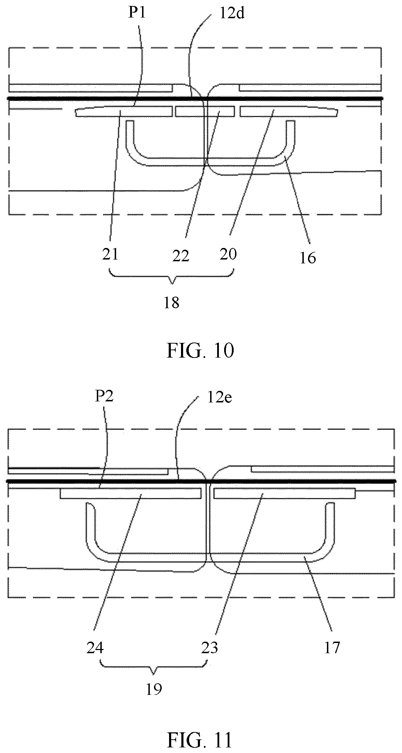

In this arrangement, in a state in which the first body portion 13 and the second body portion 14 are relatively unfolded (referring to FIG. 9 and FIG. 10), the first support plate 20 and the second support plate 21 are respectively located on two sides of the third support plate 22, and support faces P1 of the first support plate 20, the second support plate 21, and the third support plate 22 are on a same plane to jointly support the first bent-screen portion 12d from below. In a state in which the first body portion 13 and the second body portion 14 are folded to overlap each other (referring to FIG. 8), the first bent-screen portion 12d is in a water drop shape, the first support plate 20 rotates to a state of being parallel to the first transition section d1 and supports the first transition section d1 from below, the second support plate 21 rotates to a state of being parallel to the second transition section d2 and supports the second transition section d2 from below, and the third support plate 22 supports the arc section d3 from below.

Referring to FIG. 8 to FIG. 11 again, the second support structure 19 includes a fourth support plate 23 and a fifth support plate 24. The fourth support plate 23 is fixedly connected to a side that is of the second body portion 14 and that is close to the third body portion 15, and the fifth support plate 24 is fixedly connected to a side that is of the third body portion 15 and that is close to the second body portion 14.

In a state in which the third body portion 15 and the second body portion 14 are relatively unfolded (referring to FIG. 9 and FIG. 11), support faces P2 of the fourth support plate 23 and the fifth support plate 24 are on a same plane to jointly support the second bent-screen portion 12e from below.

In a state in which the third body portion 15 and the second body portion 14 are relatively folded into a folded state (referring to FIG. 8), the fourth support plate 23 synchronously rotates along with the second body portion 14 to provide support near a junction of the second screen portion 12b and the second bent-screen portion 12e, and the fifth support plate 24 synchronously rotates along with the third body portion 15 to provide support near a junction of the third screen portion 12c and the second bent-screen portion 12e.

The first support structure 18 and the second support structure 19 are also shown in the implementations shown in FIG. 6 and FIG. 7.

Certainly, in another implementation, the first support structure 18 and the second support structure 19 may alternatively be other support structures; or when the first bent-screen portion 12d and/or the second bent-screen portion 12e do/does not need an additional support, the first support structure 18 and/or the second support structure 19 may not be disposed.

Referring to FIG. 6 and FIG. 7 again, in an implementation, a front-facing camera 25 is disposed on the rear face S2 of the third body portion 15.

As shown in FIG. 6, the front-facing camera 25 penetrates the secondary display 26 disposed on the rear face S2 of the third body portion 15, so that thickness space of the secondary display 26 is used, and a requirement on a thickness of the third body portion 15 is low. In this implementation, a through hole K1 is disposed in the secondary display 26, to accommodate a front end of the front-facing camera 25. In this way, the front-facing camera 25 is shielded by only the protective glass plate 27 and is not shielded by the secondary display 26, and image quality is good.

As shown in FIG. 7, the front-facing camera 25 is located on an inner side of the secondary display 26. In other words, an in-screen camera solution is used. In this solution, a requirement on the thickness of the third body portion 15 is high. This solution may be used in combination with a design in which the included angle between the front face S1 and the rear face S2 of the third body portion 15 is zero or less than the included angle between the front face S1 and the rear face S2 of the first body portion 13. Certainly, in this solution, the front-facing camera 25 is affected by the secondary display 26. This solution may be used regardless of such impact or in combination with another solution that can reduce/eliminate the impact.

Referring to FIG. 6 and FIG. 7 again, in an implementation, the button structure 28 is disposed on the side that is of the third body portion 15 and that is away from the second body portion 14. In a folding manner in this embodiment, the side that is of the third body portion 15 and that is away from the second body portion 14 is exposed without being shielded by a rotation structure (the first rotation structure 16/second rotation structure 17) of a body portion, and it is suitable to dispose the button structure 28 on the side. In addition, as described above, when the front face S1 and the rear face S2 of the third body portion 15 are parallel or the included angle between the front face S1 and the rear face S2 of the third body portion 15 is less than the included angle between the front face S1 and the rear face S2 of the first body portion 13, a thickness of an exposed side of the third body portion 15 is large, and in particular, it is suitable to dispose the button structure 28 on the exposed side. Certainly, when the included angle between the front face S1 and the rear face S2 of the third body portion 15 is equal to the included angle between the front face S1 and the rear face S2 of the first body portion 13, a button structure 28 imposing a low thickness requirement may still be disposed on the exposed side of the third body portion 15.

Referring to FIG. 6 and FIG. 7 again, in an implementation, the foldable device 10 further includes a rear-facing camera 29 and/or a main battery 30 (the main battery 30 is a battery with a largest capacity in the foldable device 10). The rear-facing camera 29 and/or the main battery 30 may be disposed on the second body portion 14. The second body portion 14 is usually arranged as follows: The front face S1 and the rear face S2 are parallel, and the size is regular. In addition, the thickness may be set to be greater than those of the first body portion 13 and the third body portion 15, to help dispose the main battery 30 and a rear-facing camera 29 with a proper size.

Still referring to FIG. 6 and FIG. 7, in an implementation, the foldable device 10 includes a flexible-display lead-out wire 31 and an antenna 32. The flexible-display lead-out wire 31 is used for an electrical connection between the flexible display 12 and a main board of the foldable device 10, and the antenna 32 is used for transmitting and receiving a wireless signal. The flexible-display lead-out wire 31 is led out from a thinner side that is of the flexible display 12 and that corresponds to the first body portion 13, and the antenna 32 is disposed on a side that is of the third body portion 15 and that is away from the second body portion 14.

In a folding solution in this embodiment, the first body portion 13 is sandwiched between the second body portion 14 and the third body portion 15, and it is unsuitable to dispose a folded-state antenna on an edge of the first body portion 13. Therefore, the flexible-display lead-out wire 31 is led out from the edge of the first body portion 13, for example, by using a COP (chip on plastic) bending technology, and a driver chip 33 is disposed on a surface of the flexible-display lead-out wire 31, to reduce panel space that is of a body portion and that is occupied by the flexible-display lead-out wire 31. The side that is of the third body portion 15 and that is away from the second body portion 14 is not shielded, and disposing the antenna 32 on the side is not prone to affecting antenna signal quality.

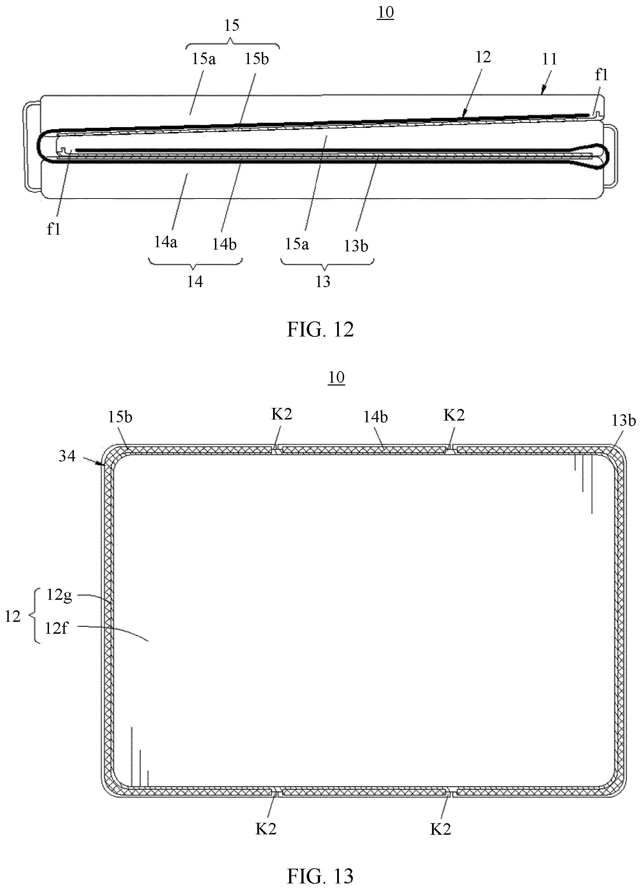

Referring to FIG. 12 and FIG. 13, in an implementation, the first body portion 13 includes a first-body-portion body 13a and a first side housing 13b connected to the first-body-portion body 13a, the second body portion 14 includes a second-body-portion body 14a and a second side housing 14b connected to the second-body-portion body 14a, and the third body portion 15 includes a third-body-portion body 15a and a third side housing 15b connected to the third-body-portion body 15a. The flexible display 12 includes a display area 12f and an outer edge area 12g located on a periphery of the display area 12f. It should be noted that dividing the flexible display 12 into the display area 12f and the outer edge area 12g, or into the first screen portion 12a, the second screen portion 12b, the third screen portion 12c, the first bent-screen portion 12d, and the second bent-screen portion 12e is merely two different division manners of the flexible display 12, and it does not mean that the flexible display 12 separately has the two structures. The flexible display 12 is laid on front faces S1 of the first-body-portion body 13a, the second-body-portion body 14a, and the third-body-portion body 15a. The first side housing 13b, the second side housing 14b, and the third side housing 15b jointly form an outer side-housing frame 34 around a periphery of the body 11. The outer edge area 12g is sandwiched between the outer side-housing frame 34 and each of the first-body-portion body 13a, the second-body-portion body 14a, and the third-body-portion body 15a, and a width-direction gap f1 exists between one or two sides of the outer side-housing frame 34 in the width direction Y1 of the foldable device 10 and a corresponding side of the flexible display 12, to allow the flexible display 12 to displace relative to a width direction the body 11 when the foldable device 10 changes between different folding states. In this implementation, attachment between the flexible display 12 and a corresponding body portion may be arranged as follows: The flexible display 12 is allowed to be misaligned with the body portion to some extent when the flexible display 12 is folded. There are a plurality of attachment methods for achieving such an effect, for example, making adhesive strength of an adhesive layer between the flexible display 12 and each of the first-body-portion body 13a and the second-body-portion body 14a small to allow a specific displacement. In this implementation, in a structural arrangement of a body portion, a displacement existing in the width direction Y1 when the flexible display 12 is bent can be allowed. In addition, the first side housing 13b, the second side housing 14b, and the third side housing 15b protrude from the outer surface of the flexible display 12, and the side housings abut against each other after folding, to prevent the flexible display 12 from being in contact with an opposite-side structure, and reduce a friction and damage possibility.

In an implementation, referring to FIG. 10, a notch K2 is disposed in each of a position that is in the outer side-housing frame 34 and that corresponds to a rotatable connection point between the first body portion 13 and the second body portion 14 and a position that is in the outer side-housing frame 34 and that corresponds to a rotatable connection point between the third body portion 15 and the second body portion 14, so that the first side housing 13b and the third side housing 15b are in U shapes with opposite openings, and separately cover three outer edges of the first-body-portion body 13a and the third-body-portion body 15a. The second side housing 14b includes upper and lower bar-shaped portions, and covers upper and lower edges of the second-body-portion body 14a. Disposing the notch K2 can avoid bending abutment between the first side housing 13b and the second side housing 14b and between the second side housing 14b and the third side housing 15b.

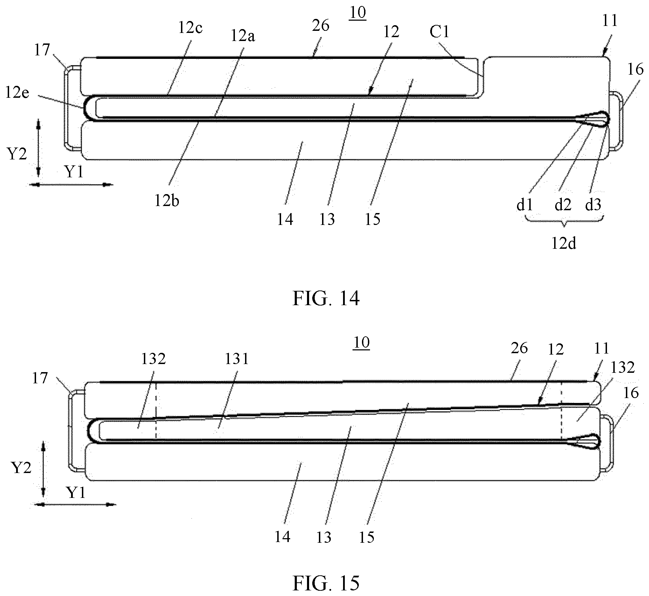

Referring to FIG. 14, an embodiment of this application further provides a foldable device 10. The foldable device 10 is also provided with a structure in which a thickness of a side that is of the first body portion 13 and that is connected to the second body portion 14 is large and a thickness of a side that is of the first body portion 13 and that is away from the second body portion 14 is small. However, the first body portion 13 is not of a wedge-shaped structure but a step-shaped structure. As shown in FIG. 14, a part that is of a rear face of the first body portion 13 and that is located on the side that is of the first body portion 13 and that is away from the second body portion 14 is recessed in a thickness direction of the first body portion 13, to form avoidance space C1, so that the first body portion 13 is in a step shape in which a thickness of a part corresponding to the avoidance space C1 is small and a thickness of a part outside the avoidance space C1 is large. The third body portion 15 is accommodated in the avoidance space C1 when overlapping the first body portion 13. In a folded state, a total thickness of the foldable device 10 is basically determined by a thickness of the second body portion 14, a thickness of the third body portion 15, and a thickness of the thinner portion of the first body portion 13, and the thickness of the thinner portion of the first body portion 13 may be set to be small, to obtain a small overall thickness. Optionally, an outer surface of a portion that protrudes outward from the side that is of the first body portion 13 and that is close to the second body portion 14 may be set to be flush with a rear face of the third body portion 15.

Referring to FIG. 15, the foldable device 10 is also provided with a structure in which a thickness of a side that is of the first body portion 13 and that is connected to the second body portion 14 is large and a thickness of a side that is of the first body portion 13 and that is away from the second body portion 14 is small. However, the first body portion 13 is not integrally in a wedge shape, but includes a wedge-shaped portion whose thickness gradually changes in a width direction and an equal-thickness portion that has constant thickness and that is connected to one or two sides in a width direction of the wedge-shaped portion. As shown in FIG. 15, the first body portion 13 includes an intermediate wedge-shaped portion 131 and equal-thickness portions 132 respectively disposed on two sides of the wedge-shaped portion 131, an equal-thickness portion 132 on a side close to the second body portion 14 is used to be connected to the second body portion, to help dispose a rotation structure at a water-drop-shaped bend, and an equal-thickness portion 132 on a side away from the second body portion 14 is used to be accommodated on an inner side of a U-shaped bend, to fully use space on the inner side of the U-shaped bend. In another implementation, only one of the two equal-thickness portions 132 may be retained. Optionally, a wedge angle of the wedge-shaped portion ranges from 0.5° to 1.8°.

It can be understood that in another implementation, the first body portion 13 may be in a form other than the form of being integrally in the wedge shape/being partially in the wedge shape/being in a step shape, to achieve a structure in which the thickness of the side connected to the second body portion 14 is large and the thickness of the side away from the second body portion 14 is small.

Based on the foregoing descriptions, in the foldable device 10 in the embodiments of this application, the inward folding manner is used between the first body portion 13 and the second body portion 14 and between the third body portion 15 and the second body portion 14, the thickness of the side that is of the first body portion 13 and that is close to the second body portion 14 is large, and the thickness of the side that is of the first body portion 13 and that is away from the second body portion 14 is small, so that design difficulty of the rotatable connection structure between the first body portion 13 and the second body portion 14 is reduced, and space existing between the second body portion 14 and the third body portion 15 after the second body portion 14 and the third body portion 15 rotate is fully used to help reduce the overall thickness of the foldable device 10. In addition, in the structure, the flexible display 12 is sandwiched between inner sides of the body portions and is difficult to damage, the flexible display 12 only needs to meet the inward folding requirement, and the requirement on performance of the flexible display 12 is low.

## Claims

1. A foldable device (10), comprising:
a body (11) and a flexible display (12), wherein
the body (11) comprises a first body portion (13), a second body portion (14), and a third body portion (15) that are sequentially disposed, and the first body portion (13) and the third body portion (15) are respectively rotatably connected to two sides in a width direction of the second body portion (14);
the flexible display (12) comprises a first screen portion (12a), a first bent-screen portion (12d), a second screen portion (12b), a second bent-screen portion (12e), and a third screen portion (12c) that are sequentially connected, the first screen portion (12a) is attached to a front face of the first body portion (13), the second screen portion (12b) is attached to a front face of the second body portion (14), and the third screen portion (12c) is attached to a front face of the third body portion (15);
the first body portion (13) is capable of being folded to overlap the second body portion (14), so that the first screen portion (12a) and the second screen portion (12b) are opposite to each other and sandwiched between the front face of the first body portion (13) and the front face of the second body portion (14); and the third body portion (15) is capable of being folded to overlap the folded first body portion (13), so that the third screen portion (12c) is sandwiched between a rear face of the first body portion (13) and the front face of the third body portion (15); and
a thickness of a side that is of the first body portion (13) and that is connected to the second body portion (14) is large, and a thickness of a side that is of the first body portion (13) and that is away from the second body portion (14) is small; wherein
a part that is of the rear face of the first body portion (13) and that is located on a side that is of the first body portion (13) and that is away from the second body portion (14) is recessed in a thickness direction of the first body portion (13), to form avoidance space (C1), so that the first body portion (13) is in a step shape in which a thickness of a part corresponding to the avoidance space (C1) is small and a thickness of a part outside the avoidance space is large;
the foldable device **characterised in that**:
the third body portion (15) is accommodated in the avoidance space (C1) when overlapping the first body portion (13) so that an overall thickness of the accommodated third body portion (15) and the first body portion (13) together is basically constant.

2. The foldable device (10) according to claim 1, wherein
in a state in which the first body portion (13) is folded to overlap the second body portion (14), the first screen portion (12a) and the second screen portion (12b) overlap each other, and the first bent-screen portion (12d) is bent into a water drop shape; and
in a state in which the third body portion (15) is folded to overlap the folded first body portion (13), the third screen portion (12c) overlaps the rear face of the first body portion (13), and the second bent-screen portion (12e) is bent into a U shape.

3. The foldable device (10) according to claim 2, wherein
in the state in which the first body portion (13) is folded to overlap the second body portion (14), the first screen portion (12a) and the second screen portion (12b) are fitted or at a distance less than 1.0 mm, the first bent-screen portion (12d) bent into the water drop shape comprises an arc section (d3), a first transition section (d1), and a second transition section (d2), the first transition section (d1) is transitionally connected between the arc section (d3) and the first screen portion (12a), and the second transition section (d2) is transitionally connected between the arc section (d3) and the second screen portion (12b).

4. The foldable device (10) according to claim 3, wherein
the first body portion (13) and the second body portion (14) are rotatably connected by using a first rotation structure (16); and
the third body portion (15) and the second body portion (14) are rotatably connected by using a second rotation structure (17).

5. The foldable device (10) according to claim 4, wherein
the first rotation structure (16) and/or the second rotation structure (17) are/is a hinge structure.

6. The foldable device (10) according to claim 5, wherein
the foldable device (10) further comprises a first support structure (18) and a second support structure (19), the first support structure (18) is configured to support the first bent-screen portion (12d), and the second support structure (19) is configured to support the second bent-screen portion (12e).

7. The foldable device (10) according to claim 6, wherein
the first support structure (18) comprises a first support plate (20), a second support plate (21), and a third support plate (22);
the first support plate (20) is rotatably connected to the first body portion (13), the second support plate (21) is rotatably connected to the second body portion (14), and the third support plate (22) is fixedly connected to the first rotation structure (16);
in a state in which the first body portion (13) and the second body portion (14) are relatively unfolded, the first support plate (20) and the second support plate (21) are respectively located on two sides of the third support plate (22), and support faces of the first support plate (20), the second support plate (21), and the third support plate (22) are on a same plane to jointly support the first bent-screen portion (12d); and
in a state in which the first body portion (13) and the second body portion (14) are folded to overlap each other, the first bent-screen portion (12d) is in the water drop shape, the first support plate (20) rotates to a state of being parallel to the first transition section (d1) and supports the first transition section (d1) from below, the second support plate (21) rotates to a state of being parallel to the second transition section (d2) and supports the second transition section (d2) from below, and the third support plate (22) supports the arc section from below.

8. The foldable device (10) according to claim 6, wherein
the second support structure (19) comprises a fourth support plate (23) and a fifth support plate (24);
the fourth support plate (23) is fixedly connected to a side that is of the second body portion (14) and that is close to the third body portion (15), and the fifth support plate (24) is fixedly connected to a side that is of the third body portion (15) and that is close to the second body portion (14);
in a state in which the third body portion (15) and the second body portion (14) are relatively unfolded, support faces of the fourth support plate (23) and the fifth support plate (24) are on a same plane to jointly support the second bent-screen portion (12e); and
in a state in which the third body portion (15) and the second body portion (14) are relatively folded into a folded state, the fourth support plate (23) synchronously rotates along with the second body portion (14) to provide support near a junction of the second screen portion (12b) and the second bent-screen portion (12e), and the fifth support plate (24) synchronously rotates along with the third body portion (15) to provide support near a junction of the third screen portion (12c) and the second bent-screen portion (12e).

9. The foldable device (10) according to claim 1, wherein
the first body portion (13) comprises a first-body-portion body (13a) and a first side housing (13b) connected to the first-body-portion body (13a), the second body portion (14) comprises a second-body-portion body (14a) and a second side housing (14b) connected to the second-body-portion body (14a), the third body portion (15) comprises a third-body-portion body (15a) and a third side housing (15b) connected to the third-body-portion body (15a), and the flexible display (12) comprises a display area (12g) and an outer edge area (12f) located on a periphery of the display area (12g);
the flexible display (12) is laid on front faces of the first-body-portion body (13a), the second-body-portion body (14a), and the third-body-portion body (15a); and
the first side housing (13b), the second side housing (14b), and the third side housing (15b) jointly form an outer side-housing frame (34) around a periphery of the body, the outer edge area (12f) is sandwiched between the outer side-housing frame (34) and each of the first-body-portion body (13a), the second-body-portion body (14a), and the third-body-portion body (15a), and a width-direction gap (f1) exists between one or two sides of the outer side-housing frame (34) in a width direction of the foldable device (10) and a corresponding side of the flexible display (12), to allow the flexible display (12) to displace relative to a width direction of the body (11) when the foldable device (10) changes between different folding states.

10. The foldable device (10) according to claim 9, wherein
a notch (K2) is disposed in each of a position that is in the outer side-housing frame (34) and that corresponds to a rotatable connection point between the first body portion (13) and the second body portion (14) and a position that is in the outer side-housing frame (34) and that corresponds to a rotatable connection point between the third body portion (15) and the second body portion (14).

## Patentansprüche

1. Eine faltbare Vorrichtung (10), umfassend:
ein Gehäuse (11) und ein flexibles Display (12), wobei
das Gehäuse (11) einen ersten Gehäuseteil (13), einen zweiten Gehäuseteil (14) und einen dritten Gehäuseteil (15) umfasst, die in Reihe angeordnet sind, und wobei der erste Gehäuseteil (13) und der dritte Gehäuseteil (15) jeweils drehbar mit zwei Seiten in Breitenrichtung des zweiten Gehäuseteils (14) verbunden sind;
das flexible Display (12) umfasst einen ersten Bildschirmabschnitt (12a), einen ersten gebogenen Bildschirmabschnitt (12d), einen zweiten Bildschirmabschnitt (12b), einen zweiten gebogenen Bildschirmabschnitt (12e) und einen dritten Bildschirmabschnitt (12c), die nacheinander verbunden sind; der erste Bildschirmabschnitt (12a) ist an einer Vorderseite des ersten Gehäuseteils (13) befestigt, der zweite Bildschirmabschnitt (12b) ist an einer Vorderseite des zweiten Gehäuseteils (14) befestigt und der dritte Bildschirmabschnitt (12c) ist an einer Vorderseite des dritten Gehäuseteils (15) befestigt;
der erste Gehäuseteil (13) kann so gefaltet werden, dass er den zweiten Gehäuseteil (14) überlappt, so dass der erste Bildschirmabschnitt (12a) und der zweite Bildschirmabschnitt (12b) einander gegenüberliegen und zwischen der Vorderseite des ersten Gehäuseteils (13) und der Vorderseite des zweiten Gehäuseteils (14) eingeschlossen sind; und der dritte Gehäuseteil (15) kann so gefaltet werden, dass er den gefalteten ersten Gehäuseteil (13) überlappt, so dass der dritte Bildschirmabschnitt (12c) zwischen einer Rückseite des ersten Gehäuseteils (13) und der Vorderseite des dritten Gehäuseteils (15) eingeschlossen ist; und
die Dicke einer Seite des ersten Gehäuseteils (13), die mit dem zweiten Gehäuseteil (14) verbunden ist, ist groß, und die Dicke einer Seite des ersten Gehäuseteils (13), die vom zweiten Gehäuseteil (14) entfernt ist, ist klein; wobei
ein Teil der Rückseite des ersten Gehäuseteils (13), der sich an einer vom zweiten Gehäuseteil (14) entfernten Seite des ersten Gehäuseteils (13) befindet, in Dickentrichtung des ersten Gehäuseteils (13) eingesenkt ist, um einen Aussparraum (C1) zu bilden, so dass der erste Gehäuseteil (13) eine stufenförmige Struktur aufweist, bei der die Dicke eines dem Aussparraum (C1) entsprechenden Teils gering ist und die Dicke eines außerhalb des Aussparraums liegenden Teils groß ist; wobei die faltbare Vorrichtung
**dadurch gekennzeichnet** ist:
der dritte Gehäuseteil (15) im Aussparraum (C1) aufgenommen wird, wenn er den ersten Gehäuseteil (13) überlappt, so dass die Gesamtdicke des aufgenommenen dritten Gehäuseteils (15) und des ersten Gehäuseteils (13) gemeinsam im Wesentlichen konstant bleibt.

2. Die faltbare Vorrichtung (10) gemäß Anspruch 1, wobei
in einem Zustand, in dem der erste Gehäuseteil (13) so gefaltet ist, dass er den zweiten Gehäuseteil (14) überlappt, die erste Bildschirmfläche (12a) und die zweite Bildschirmfläche (12b) einander überlappen und der erste gebogene Bildschirmabschnitt (12d) tropfenförmig gebogen ist; und
in einem Zustand, in dem der dritte Gehäuseteil (15) so gefaltet ist, dass er den gefalteten ersten Gehäuseteil (13) überlappt, die dritte Bildschirmfläche (12c) die Rückseite des ersten Gehäuseteils (13) überlappt und der zweite gebogene Bildschirmabschnitt (12e) U-förmig gebogen ist.

3. Die faltbare Vorrichtung (10) nach Anspruch 2, wobei
in dem Zustand, in dem der erste Gehäuseteil (13) so gefaltet ist, dass er den zweiten Gehäuseteil (14) überlappt, die erste Bildschirmfläche (12a) und die zweite Bildschirmfläche (12b) anliegen oder einen Abstand von weniger als 1,0 mm haben, der tropfenförmig gebogene erste Bildschirmabschnitt (12d) einen Bogenabschnitt (d3), einen ersten Übergangsabschnitt (d1) und einen zweiten Übergangsabschnitt (d2) umfasst, wobei der erste Übergangsabschnitt (d1) zwischen dem Bogenabschnitt (d3) und der ersten Bildschirmfläche (12a) übergangsweise verbunden ist und der zweite Übergangsabschnitt (d2) zwischen dem Bogenabschnitt (d3) und der zweiten Bildschirmfläche (12b) übergangsweise verbunden ist.

4. Die faltbare Vorrichtung (10) nach Anspruch 3, wobei
der erste Gehäuseteil (13) und der zweite Gehäuseteil (14) drehbar durch eine erste Rotationsstruktur (16) miteinander verbunden sind; und
der dritte Gehäuseteil (15) und der zweite Gehäuseteil (14) drehbar durch eine zweite Rotationsstruktur (17) miteinander verbunden sind.

5. Die faltbare Vorrichtung (10) nach Anspruch 4, wobei
die erste Rotationsstruktur (16) und/oder die zweite Rotationsstruktur (17) eine Scharnierstruktur ist/sind.

6. Die faltbare Vorrichtung (10) nach Anspruch 5, wobei
die faltbare Vorrichtung (10) außerdem eine erste Stützstruktur (18) und eine zweite Stützstruktur (19) umfasst, wobei die erste Stützstruktur (18) dazu ausgelegt ist, den ersten gebogenen Bildschirmabschnitt (12d) zu stützen, und die zweite Stützstruktur (19) dazu ausgelegt ist, den zweiten gebogenen Bildschirmabschnitt (12e) zu stützen.

7. Die faltbare Vorrichtung (10) nach Anspruch 6, wobei
die erste Stützstruktur (18) eine erste Stützplatte (20), eine zweite Stützplatte (21) und eine dritte Stützplatte (22) umfasst;
die erste Stützplatte (20) ist drehbar mit dem ersten Gehäuseteil (13) verbunden, die zweite Stützplatte (21) ist drehbar mit dem zweiten Gehäuseteil (14) verbunden und die dritte Stützplatte (22) ist fest mit der ersten Rotationsstruktur (16) verbunden;
In einem Zustand, in dem der erste Gehäuseteil (13) und der zweite Gehäuseteil (14) relativ entfaltet sind, befinden sich die erste Stützplatte (20) und die zweite Stützplatte (21) jeweils auf zwei Seiten der dritten Stützplatte (22), und die Stützflächen der ersten Stützplatte (20), der zweiten Stützplatte (21) und der dritten Stützplatte (22) liegen in einer gemeinsamen Ebene, um gemeinsam den ersten Biege-Bildschirmabschnitt (12d) zu stützen; und
In einem Zustand, in dem der erste Gehäuseteil (13) und der zweite Gehäuseteil (14) zusammengefaltet sind und sich überlappen, befindet sich der erste Biege-Bildschirmabschnitt (12d) in Tropfenform, die erste Stützplatte (20) dreht sich in eine Position, die parallel zum ersten Übergangsabschnitt (d1) liegt und stützt den ersten Übergangsabschnitt (d1) von unten, die zweite Stützplatte (21) dreht sich in eine Position, die parallel zum zweiten Übergangsabschnitt (d2) liegt und stützt den zweiten Übergangsabschnitt (d2) von unten, und die dritte Stützplatte (22) stützt den Bogenabschnitt von unten.

8. Die faltbare Vorrichtung (10) nach Anspruch 6, wobei
die zweite Stützstruktur (19) eine vierte Stützplatte (23) und eine fünfte Stützplatte (24) umfasst;
die vierte Stützplatte (23) ist fest mit einer dem dritten Gehäuseteil (15) zugewandten Seite des zweiten Gehäuseteils (14) verbunden, und die fünfte Stützplatte (24) ist fest mit einer dem zweiten Gehäuseteil (14) zugewandten Seite des dritten Gehäuseteils (15) verbunden;
In einem Zustand, in dem der dritte Gehäuseteil (15) und der zweite Gehäuseteil (14) relativ entfaltet sind, liegen die Stützflächen der vierten Stützplatte (23) und der fünften Stützplatte (24) in einer gemeinsamen Ebene, um gemeinsam den zweiten Biege-Bildschirmabschnitt (12e) zu stützen; und
In einem Zustand, in dem der dritte Gehäuseteil (15) und der zweite Gehäuseteil (14) relativ zusammengefaltet sind, rotiert die vierte Stützplatte (23) synchron mit dem zweiten Gehäuseteil (14), um nahe der Verbindung zwischen dem zweiten Bildschirmabschnitt (12b) und dem zweiten Biege-Bildschirmabschnitt (12e) Unterstützung zu bieten, und die fünfte Stützplatte (24) rotiert synchron mit dem dritten Gehäuseteil (15), um nahe der Verbindung zwischen dem dritten Bildschirmabschnitt (12c) und dem zweiten Biege-Bildschirmabschnitt (12e) Unterstützung zu bieten.

9. Die faltbare Vorrichtung (10) nach Anspruch 1, wobei
Der erste Körperabschnitt (13) umfasst einen ersten Körperabschnitt-Körper (13a) und ein erstes Seitengehäuse (13b), das mit dem ersten Körperabschnitt-Körper (13a) verbunden ist, der zweite Körperabschnitt (14) umfasst einen zweiten Körperabschnitt-Körper (14a) und ein zweites Seitengehäuse (14b), das mit dem zweiten Körperabschnitt-Körper (14a) verbunden ist, der dritte Körperabschnitt (15) umfasst einen dritten Körperabschnitt-Körper (15a) und ein drittes Seitengehäuse (15b), das mit dem dritten Körperabschnitt-Körper (15a) verbunden ist, und das flexible Display (12) umfasst einen Anzeigebereich (12g) und einen Außenrandbereich (12f), der sich am Umfang des Anzeigebereichs (12g) befindet;
Das flexible Display (12) ist auf den Vorderseiten des ersten Körperabschnitt-Körpers (13a), des zweiten Körperabschnitt-Körpers (14a) und des dritten Körperabschnitt-Körpers (15a) angeordnet; und
Das erste Seitengehäuse (13b), das zweite Seitengehäuse (14b) und das dritte Seitengehäuse (15b) bilden gemeinsam einen äußeren Seitengehäuserahmen (34) um den Umfang des Körpers, wobei der Außenrandbereich (12f) zwischen dem äußeren Seitengehäuserahmen (34) und jeweils dem ersten Körperabschnitt-Körper (13a), dem zweiten Körperabschnitt-Körper (14a) und dem dritten Körperabschnitt-Körper (15a) eingeschlossen ist, und ein Spalt in Breitenrichtung (f1) besteht zwischen einer oder zwei Seiten des äußeren Seitengehäuserahmens (34) in der Breitenrichtung des faltbaren Geräts (10) und einer entsprechenden Seite des flexiblen Displays (12), sodass sich das flexible Display (12) relativ zur Breitenrichtung des Körpers (11) verschieben kann, wenn das faltbare Gerät (10) zwischen verschiedenen Faltzuständen wechselt.

10. Faltvorrichtung (10) nach Anspruch 9, wobei
eine Aussparung (K2) jeweils an einer Position, die sich im äußeren Seitengehäuserahmen (34) befindet und einem drehbaren Verbindungspunkt zwischen dem ersten Körperabschnitt (13) und dem zweiten Körperabschnitt (14) entspricht, sowie an einer Position, die sich im äußeren Seitengehäuserahmen (34) befindet und einem drehbaren Verbindungspunkt zwischen dem dritten Körperabschnitt (15) und dem zweiten Körperabschnitt (14) entspricht, angeordnet ist.

## Revendications

1. Dispositif pliable (10), comprenant :
un corps (11) et un écran flexible (12), dans lequel
le corps (11) comprend une première partie de corps (13), une deuxième partie de corps (14) et une troisième partie de corps (15) disposées séquentiellement, et la première partie de corps (13) et la troisième partie de corps (15) sont raccordées respectivement de façon rotative aux deux côtés dans la direction de la largeur de la deuxième partie de corps (14) ;
l'écran flexible (12) comprend une première portion d'écran (12a), une première portion d'écran courbée (12d), une deuxième portion d'écran (12b), une deuxième portion d'écran courbée (12e) et une troisième portion d'écran (12c) reliées de manière séquentielle, la première portion d'écran (12a) étant attachée à la face avant de la première partie de corps (13), la deuxième portion d'écran (12b) étant attachée à la face avant de la deuxième partie de corps (14), et la troisième portion d'écran (12c) étant attachée à la face avant de la troisième partie de corps (15) ;
la première partie de corps (13) peut être pliée de façon à recouvrir la deuxième partie de corps (14), de sorte que la première portion d'écran (12a) et la deuxième portion d'écran (12b) se font face et sont prises en sandwich entre la face avant de la première partie de corps (13) et la face avant de la deuxième partie de corps (14); et la troisième partie de corps (15) peut être pliée pour recouvrir la première partie de corps (13) déjà pliée, de sorte que la troisième portion d'écran (12c) est prise en sandwich entre la face arrière de la première partie de corps (13) et la face avant de la troisième partie de corps (15) ; et
l'épaisseur d'un côté de la première partie de corps (13) relié à la deuxième partie de corps (14) est grande, et l'épaisseur du côté de la première partie de corps (13) opposé à la deuxième partie de corps (14) est faible ; dans lequel
une partie de la face arrière de la première partie de corps (13), située du côté opposé à la deuxième partie de corps (14), est en retrait dans la direction de l'épaisseur de la première partie de corps (13), formant un espace d'évitement (C1), de sorte que la première partie de corps (13) ait une forme en escalier, dans laquelle l'épaisseur de la partie correspondant à l'espace d'évitement (C1) est faible et l'épaisseur de la partie hors de l'espace d'évitement est grande ; le dispositif pliable étant **caractérisé en ce que** :
la troisième partie de corps (15) est logée dans l'espace d'évitement (C1) lorsqu'elle recouvre la première partie de corps (13), de sorte que l'épaisseur totale de l'ensemble constitué de la troisième partie de corps (15) logée et de la première partie de corps (13) soit sensiblement constante.

2. Dispositif pliable (10) selon la revendication 1, dans lequel
dans un état dans lequel la première partie de corps (13) est repliée pour recouvrir la deuxième partie de corps (14), la première partie d'écran (12a) et la deuxième partie d'écran (12b) se superposent, et la première partie d'écran courbée (12d) est pliée en forme de goutte d'eau ; et
dans un état dans lequel la troisième partie de corps (15) est repliée pour recouvrir la première partie de corps pliée (13), la troisième partie d'écran (12c) recouvre la face arrière de la première partie de corps (13), et la seconde partie d'écran courbée (12e) est pliée en forme de U.

3. Le dispositif pliable (10) selon la revendication 2, dans lequel
dans l'état dans lequel la première partie de corps (13) est repliée afin de recouvrir la deuxième partie de corps (14), la première partie d'écran (12a) et la deuxième partie d'écran (12b) sont ajustées l'une contre l'autre ou séparées par une distance inférieure à 1,0 mm, la première partie d'écran courbée (12d) pliée en forme de goutte d'eau comprend une section arquée (d3), une première section de transition (d1) et une seconde section de transition (d2), la première section de transition (d1) étant connectée de manière transitoire entre la section arquée (d3) et la première partie d'écran (12a), et la seconde section de transition (d2) étant connectée de manière transitoire entre la section arquée (d3) et la deuxième partie d'écran (12b).

4. Le dispositif pliable (10) selon la revendication 3, dans lequel
la première partie de corps (13) et la deuxième partie de corps (14) sont reliées rota-tivement à l'aide d'une première structure de rotation (16) ; et
la troisième partie de corps (15) et la deuxième partie de corps (14) sont reliées ro-tativement à l'aide d'une seconde structure de rotation (17).

5. Le dispositif pliable (10) selon la revendication 4, dans lequel
la première structure de rotation (16) et/ou la seconde structure de rotation (17) est/sont une structure de charnière.

6. Le dispositif pliable (10) selon la revendication 5, dans lequel
le dispositif pliable (10) comprend en outre une première structure de support (18) et une seconde structure de support (19), la première structure de support (18) étant conçue pour soutenir la première partie d'écran courbée (12d), et la seconde structure de support (19) étant conçue pour soutenir la seconde partie d'écran courbée (12e).

7. Le dispositif pliable (10) selon la revendication 6, dans lequel
la première structure de support (18) comprend une première plaque de support (20), une deuxième plaque de support (21) et une troisième plaque de support (22) ;
la première plaque de support (20) est reliée de façon rotative à la première partie de corps (13), la deuxième plaque de support (21) est reliée de façon rotative à la deuxième partie de corps (14), et la troisième plaque de support (22) est fixement reliée à la première structure de rotation (16) ;
dans un état dans lequel la première partie du corps (13) et la deuxième partie du corps (14) sont relativement déployées, la première plaque de soutien (20) et la deuxième plaque de soutien (21) sont respectivement situées de chaque côté de la troisième plaque de soutien (22), et les faces de soutien de la première plaque de soutien (20), de la deuxième plaque de soutien (21) et de la troisième plaque de soutien (22) sont situées sur un même plan pour soutenir conjointement la première partie d'écran incurvé (12d) ; et
dans un état dans lequel la première partie du corps (13) et la deuxième partie du corps (14) sont repliées l'une sur l'autre, la première partie d'écran incurvé (12d) prend la forme d'une goutte d'eau, la première plaque de soutien (20) pivote jusqu'à être parallèle à la première section de transition (d1) et soutient la première section de transition (d1) par en dessous, la deuxième plaque de soutien (21) pivote jusqu'à être parallèle à la deuxième section de transition (d2) et soutient la deuxième section de transition (d2) par en dessous, et la troisième plaque de soutien (22) soutient la section en arc par en dessous.

8. Le dispositif pliable (10) selon la revendication 6, dans lequel
la deuxième structure de soutien (19) comprend une quatrième plaque de soutien (23) et une cinquième plaque de soutien (24) ;
la quatrième plaque de soutien (23) est fixée de manière permanente sur un côté de la deuxième partie du corps (14) du côté proche de la troisième partie du corps (15), et la cinquième plaque de soutien (24) est fixée de manière permanente sur un côté de la troisième partie du corps (15) du côté proche de la deuxième partie du corps (14) ;
dans un état dans lequel la troisième partie du corps (15) et la deuxième partie du corps (14) sont relativement déployées, les faces de soutien de la quatrième plaque de soutien (23) et de la cinquième plaque de soutien (24) sont situées sur un même plan pour soutenir conjointement la deuxième partie d'écran incurvé (12e) ; et
dans un état dans lequel la troisième partie du corps (15) et la deuxième partie du corps (14) sont repliées l'une sur l'autre, la quatrième plaque de soutien (23) pivote de façon synchrone avec la deuxième partie du corps (14) pour fournir un soutien près de la jonction de la deuxième partie d'écran (12b) et de la deuxième partie d'écran incurvé (12e), et la cinquième plaque de soutien (24) pivote de façon synchrone avec la troisième partie du corps (15) pour fournir un soutien près de la jonction de la troisième partie d'écran (12c) et de la deuxième partie d'écran incurvé (12e).

9. Le dispositif pliable (10) selon la revendication 1, dans lequel
la première partie du corps (13) comprend un corps de première partie (13a) et un premier boîtier latéral (13b) connecté au corps de la première partie (13a), la seconde partie du corps (14) comprend un corps de seconde partie (14a) et un second boîtier latéral (14b) connecté au corps de la seconde partie (14a), la troisième partie du corps (15) comprend un corps de troisième partie (15a) et un troisième boîtier latéral (15b) connecté au corps de la troisième partie (15a), et l'affichage flexible (12) comprend une zone d'affichage (12g) et une zone de bord extérieur (12f) située en périphérie de la zone d'affichage (12g) ;
l'affichage flexible (12) est placé sur les faces avant du corps de la première partie (13a), du corps de la seconde partie (14a) et du corps de la troisième partie (15a) ; et
le premier boîtier latéral (13b), le second boîtier latéral (14b) et le troisième boîtier latéral (15b) forment conjointement un cadre de boîtier latéral extérieur (34) autour de la périphérie du corps, la zone de bord extérieur (12f) est prise en sandwich entre le cadre de boîtier latéral extérieur (34) et chacun des corps de la première partie (13a), de la seconde partie (14a) et de la troisième partie (15a), et un espace en direction de la largeur (f1) existe entre un ou deux côtés du cadre de boîtier latéral extérieur (34) dans la direction de la largeur du dispositif pliable (10) et le côté correspondant de l'affichage flexible (12), afin de permettre à l'affichage flexible (12) de se déplacer par rapport à la direction de la largeur du corps (11) lorsque le dispositif pliable (10) passe entre différents états de pliage.

10. Le dispositif pliable (10) selon la revendication 9, dans lequel
une encoche (K2) est disposée dans chacune des positions situées dans le cadre de boîtier latéral extérieur (34) et correspondant à un point de connexion rotatif entre la première partie du corps (13) et la seconde partie du corps (14), et à une position qui se trouve dans le cadre de boîtier latéral extérieur (34) et qui correspond à un point de connexion rotatif entre la troisième partie du corps (15) et la seconde partie du corps (14).
